# EUROPEAN PATENT SPECIFICATION

(11) **EP 0 381 338 B1**
(45) Date of publication and mention of the grant of the patent: **22.06.1994**
(21) Application number: 90300534.6
(22) Date of filing: 18.01.1990
(51) Int. Cl.: H01L 21/00, C23C 16/54

(54) **Method and apparatus for the transfer of wafers in a vertical cvd diffusion apparatus**
Verfahren und Vorrichtung zum Transport von Halbleiterplättchen in einem vertikalen Diffusionsapparat mit chemischer Aufdampfung
Procédé et dispositif de transfert de plaquettes semi-conductrices dans un appareil vertical de diffusion à dépôt de vapeur chimique

(30) Priority: 28.01.1989 JP 19230/89
(43) Date of publication of application: 08.08.1990
(73) Proprietor: KOKUSAI ELECTRIC CO., LTD., Tokyo-to (JP)
(72) Inventor: Harada, Yasuhiro, Ome-shi, Tokyo-to (JP); Karino, Toshikazu, Higashimurayama-shi, Tokyo-to (JP); Saito, Ryoji, Nishitama-gun, Tokyo-to (JP); Tometsuka, Koji, Nishitama-gun, Tokyo-to (JP); Izumi, Shoichiro, Nishitama-gun, Tokyo-to (JP)
(74) Representative: Jennings, Nigel Robin

(56) References cited:
- GB-A- 2 190 345
- JP-A-63 314 843
- US-A- 4 759 681
- PATENT ABSTRACTS OF JAPAN vol. 11, no. 351 (E-557)(2798) 17 November 1987, & JP-A-62 130534

## Description

The present invention relates to the transfer of wafers in a vertical CVD (Chemical Vapour Deposition) diffusion apparatus.

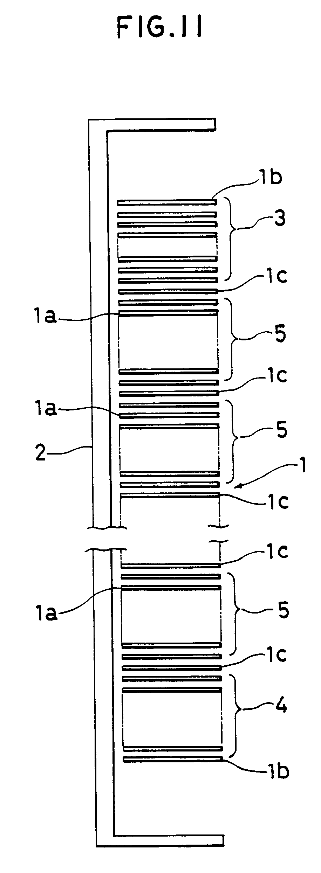

Nowadays, the manufacturing process of semiconductor elements or chips includes a CVD diffusion treatment stage. In the treatment stage, a predetermined number of silicon wafers are heated in a CVD diffusion apparatus in order to deposit material chemically on the silicon wafers. Known methods of manufacturing semiconductor chips will now be described with reference to Figures 11 to 13 of the accompanying drawings, in which:-
Figure 11 shows a number of wafers stacked in a boat;
Figure 12 shows a conventional one by one type wafer transport mechanism; and
Figure 13 shows a conventional collective type wafer transport mechanism.

Conventionally, wafers are arranged in a column, as shown in Figure 11, with a number of dummy wafers at the top and bottom of the column sandwiching the product wafers in the middle of the column. In this arrangement, material is uniformly and homogeneously deposited on the wafers. Single monitor wafers are inserted at predetermined positions between the product wafers.

Referring to Figure 11, a group of wafers 1 is supported or held in the boat 2 in a diffusion furnace 12 in order to apply the CVD diffusion treatment to the wafers. The wafers are arranged in a predetermined manner and inserted into the boat 2 which is then placed in the diffusion furnace 12. In general, the temperature distribution in the interior of the diffusion furnace is not homogeneous. As a consequence, the boat 2 cannot hold as many wafers as might otherwise be possible, and there is space in a loaded boat 2 which is not used for product wafers. This space could accommodate, for example, half as many wafers again. When the number of wafers to be treated is relatively small, the product wafers are placed in a portion of the boat which, when the boat is inside the furnace, occupies a part of the furnace having a uniform temperature distribution.

Two dummy wafer groups 3 and 4 consisting of a suitable number of dummy wafers 1b, are situated at the upper and lower ends, respectively, of the wafer arrangement in the boat 2. Between the dummy wafer groups 3 and 4, there is a group of product wafers 5 consisting of a predetermined number of products wafers 1a. Single monitor wafers 1c are inserted into the group of product wafers 5 at suitable positions. A monitor wafer 1c is placed between the lowest product wafer group 5 and the dummy wafer group 4.

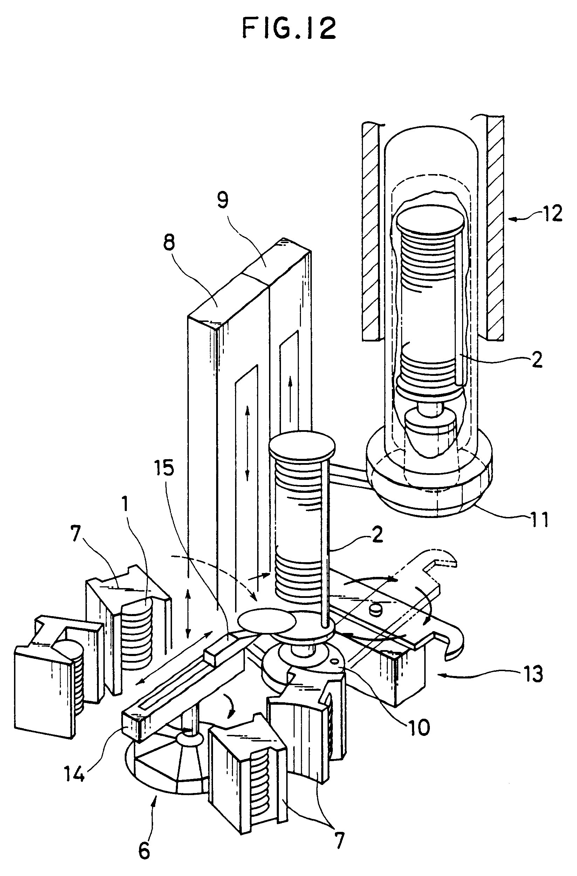

Figure 12 shows a conventional wafer transfer mechanism for transferring untreated wafers loaded in a cassette 7 to the boat 2 and returning treated wafers to a vacant cassette 7. Such a mechanism is disclosed in JP-A-63314843. The wafer transfer mechanism shown in Figure 12 operates by transferring wafers one by one and is called a one-by-one type. As is apparent from the drawing, the mechanism has a handling unit 6, around which there is a predetermined number of cassettes 7 holding wafers 1, the cassettes being situated on the circumference of a circle. A transfer elevator 8 and a load/unload elevator 9 are situated near the handling unit 6. The boat receiving stand 10 of the transfer elevator 8 is arranged to move vertically beside the vertical diffusion furnace 12. The furnace 12 is situated above the boat receiving stand 11 of the wafer load/unload elevator 9. A shifting unit 13 for shifting boats 2 is installed between the elevators 8 and 9.

The handling unit 6 has a rotating arm 14 which may rotate around the centre of the circle on which the cassettes 7 are located, and may also move vertically. A chuck 15 is mounted on the rotating arm 14 so as to be movable along the length of the arm. The chuck is adapted to receive and retain a wafer by suction. The chuck 15 engages the wafers 1 loaded in the cassette 7 one at a time. Each wafer is taken out of the cassette 7 and placed successively upon the top wafer of the wafer group in the boat 2 on the elevator 8. The transfer elevator 8 descends incrementally as the wafers are transferred. When the transfer of wafers 1 from the cassettes 7 to the boat 2 is completed, the boat 2 is shifted from the transfer elevator 8 to the load/unload elevator 9 by the shifting unit 13 and then the load/unload elevator 9 feeds the boat 2 into the diffusion furnace 12.

The CVD diffusion treatment is completed and the treated boat-load of wafers is taken out of the diffusion furnace 12. The boat 2 is then shifted to the transfer elevator 8 by means of the shifting unit 13 and the sequence involving the handling unit 6 is reversed, the wafers being reloaded into a cassette 7.

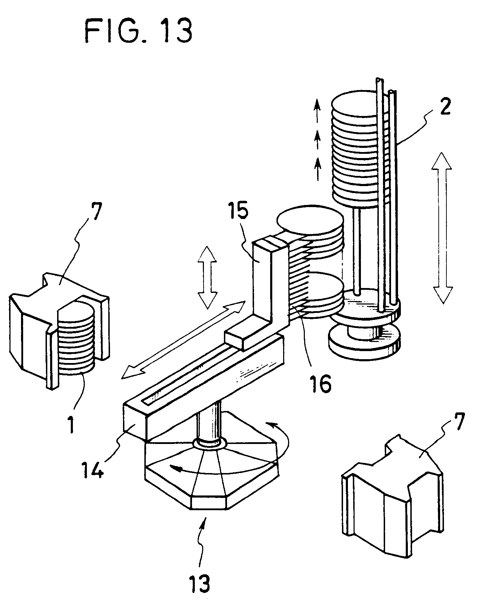

In the wafer transfer mechanism shown in Figure 13, the wafer-sucking chuck 15 has a set of twenty five sucking plates 16. All the sucking plates 16 function simultaneously and the chuck 15 thus engages 25 wafers at once and can transfer, for example, the whole contents of a cassette collectively to the boat 2.

These two types of wafer transfer mechanism of the one-by-one type and the collective type have certain shortcomings.

The arrangement of dummy wafers, monitor wafers and product wafers in a boat and their respective numbers are variable. These parameters depend upon the specific treatment required. The one-by-one type of wafer transfer mechanism may be used to create any arrangement of wafers. However, this mechanism requires many cycles of operation to fill a boat and this takes a long time; thus the efficiency of the mechanism is poor. The large number of operation cycles increases the possibility of dust being generated from and around the moving parts of the mechanism, detracting from the quality of the product wafers or semiconductor chips.

The collective type of wafer transfer mechanism takes only a short time to transfer a boat load of wafers, and accordingly the efficiency is very good.

However, since the mechanism handles and treats twenty five wafers collectively, it is impossible to vary the arrangement of the wafers during the transfer stage. As a result, it is always necessary to arrange the product wafers, dummy wafers and monitor wafers into the desired arrangement in a cassette prior to the transfer step. In this mechanism, the wafers are manually placed in the cassettes. The arranging of the various kinds of wafers in the predetermined or desired pattern is very complicated and the efficiency of the mechanism is thus reduced and errors in the arrangement of the wafers are common.

A machine is disclosed in Japanese Utility Model Application No. 62-130534 which may effectively transfer five wafers at a time to a boat, using a partly bulk transfer type mechanism.

It is an object of the present invention to combine the characteristics of the one-by-one type and the collective type of the wafer transfer mechanism so that the merits of both may be achieved. It is a further object of the present invention to provide a wafer transfer mechanism including control apparatus, and a wafer transfer method which will operate efficiently whilst eliminating human error in arranging the wafers.

According to the present invention a method of transferring product wafers, dummy wafers and monitor wafers between respective stores and a boat in which the wafers are in a predetermined arrangement in a vertical chemical vapour deposition diffusion apparatus is characterised in that the product wafers are transferred in batches of five, the dummy wafers are transferred in batches of five or less and the monitor wafers are transferred individually. The dummy wafers are normally positioned at the top and bottom of the boat and it is preferred that the total number of dummy wafers is a multiple of five.

In one embodiment of the invention the number of dummy wafers at the bottom of the boat is more than five and the method includes positioning a multiple of five dummy wafers at the top of the boat and at the bottom of the boat and then transferring a number of dummy wafers which is less than five from the top of the boat to the bottom of the boat below those dummy wafers which have already been positioned. Alternatively, the number of dummy wafers in the bottom of the boat may be less than five and in this event the method preferably includes transferring less than five dummy wafers from a batch of five such wafers to the top of the boat, transferring the product wafers and monitor wafers into the boat and then transferring the remainder of the batch of five dummy wafers to the bottom of the boat.

The invention also embraces a mechanism for carrying out such a method and according to a further aspect of the present invention a wafer transfer mechanism for transferring product wafers, monitor wafers and dummy wafers between respective storage cassettes and a boat in a chemical vapour deposition diffusion apparatus, the mechanism comprising a wafer chuck, a rotatable slide mechanism for moving the wafer chuck in the radial direction and a transfer elevator, is characterised in that the transfer elevator is arranged to move the slide mechanism vertically, that a cassette store is situated adjacent the transfer elevator and that the wafer chuck is constructed to engage and retain five wafers at a time.

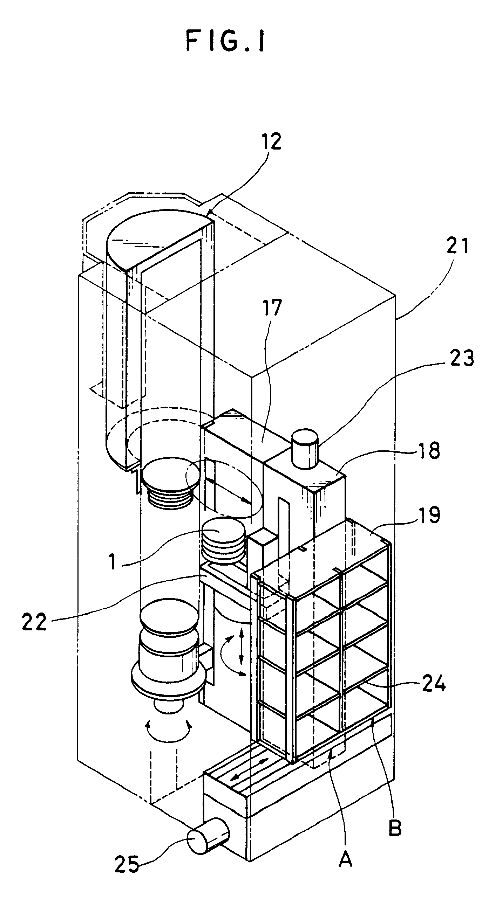

One embodiment of the wafer transfer apparatus, including transfer control apparatus, and the wafer transfer method of the present invention will now be described by way of example with reference to Figures 1 to 10 of the accompanying drawings, in which:-
Figure 1 is a perspective view of a vertical CVD diffusion apparatus showing the essential parts of the apparatus including a wafer transfer mechanism according to the invention;

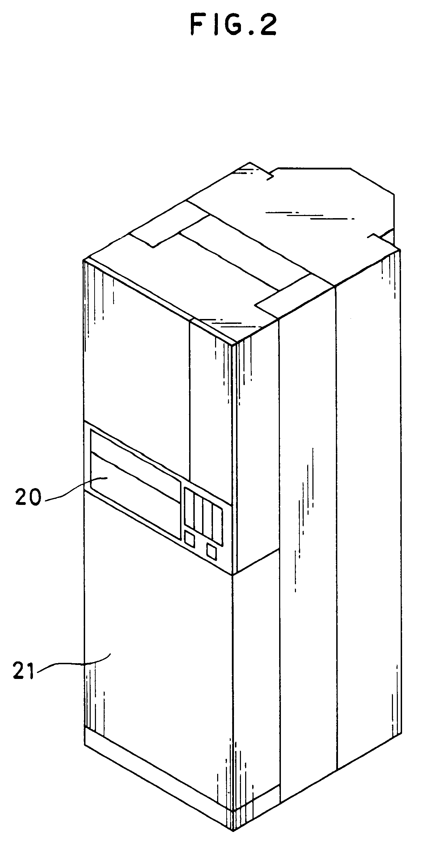

Figure 2 is a perspective view of the CVD diffusion apparatus;

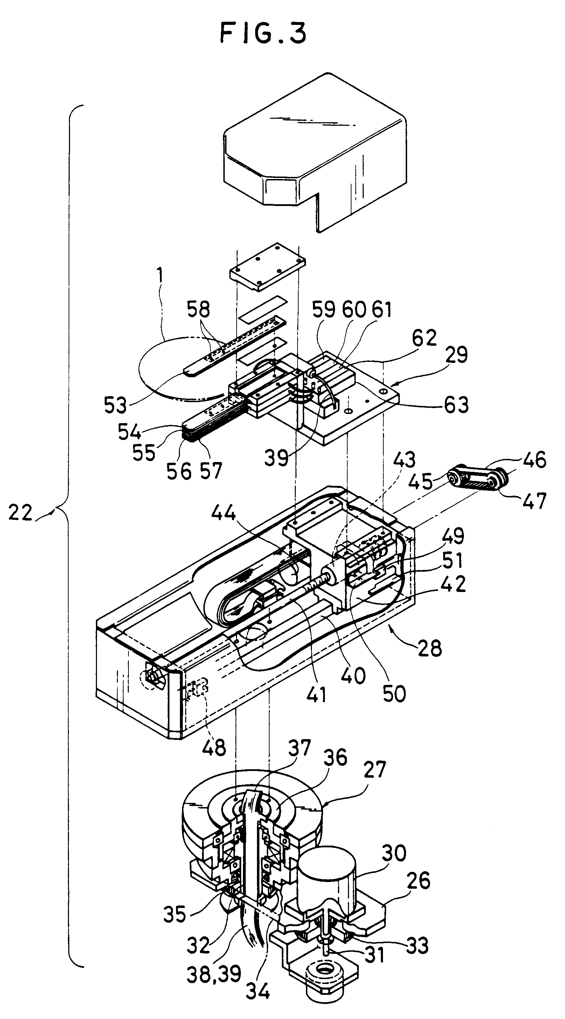

Figure 3 is an exploded perspective view of the handling unit;

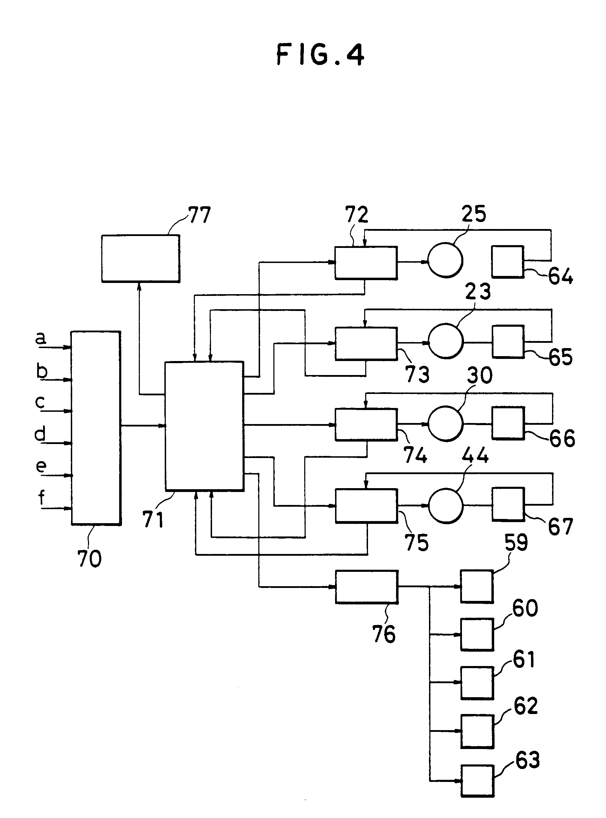

Figure 4 is a block diagram of the transfer control apparatus;

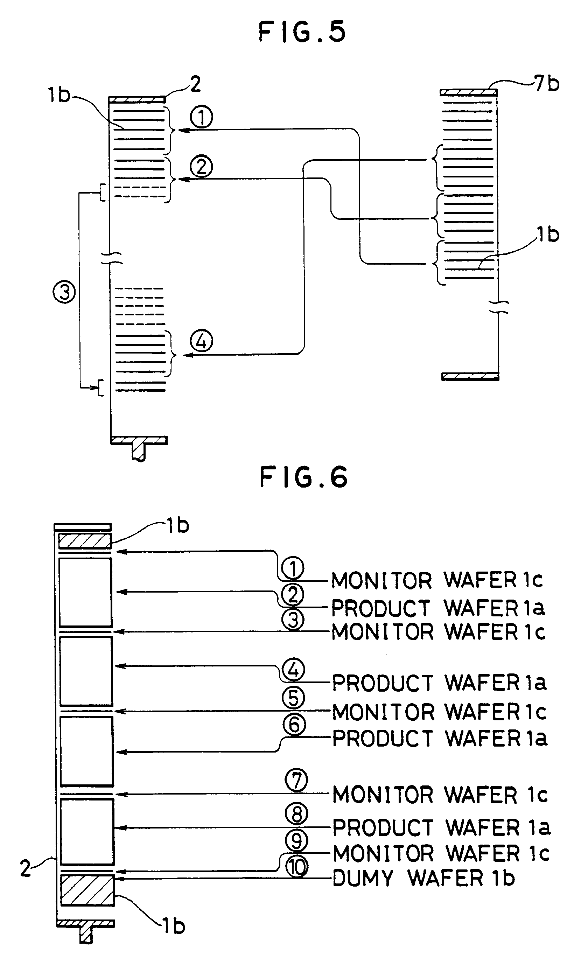

Figures 5 to 9 are schematic diagrams showing the sequence of operations in the method according to the invention; and

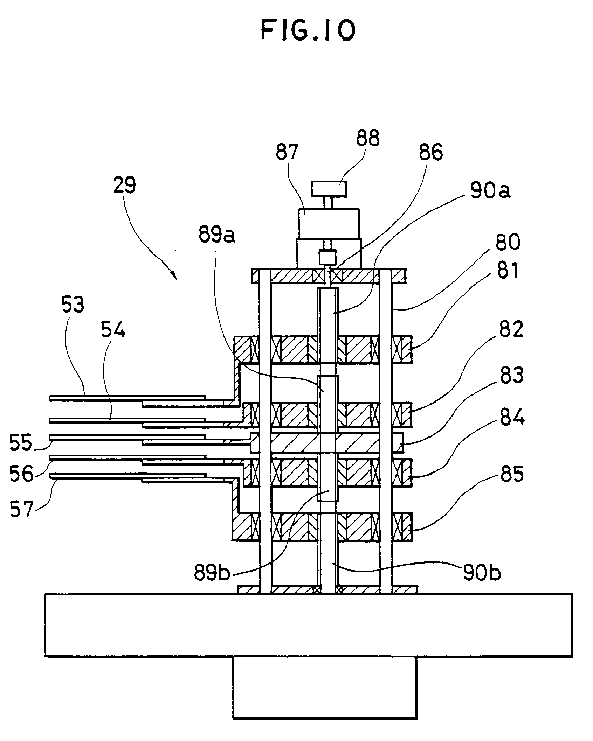

Figure 10 is a sectional view of a modified embodiment of the wafer chuck.

Referring to Figures 1 and 2, the wafer transfer mechanism 21 is associated with a diffusion furnace 12 and comprises a load/unload elevator 17, a transfer elevator 18 and a cassette store 19. The transfer mechanism includes an operation panel 20. The load/unload elevator 17 moves the boat 2 vertically into and out of the diffusion furnace 12.

The transfer elevator 18 has a handling unit 22 which is moved up and down by an elevating motor 23. The cassette store 19 has cassette storing compartments 24 arranged in a number of rows (four rows in the embodiment shown in Figure 1) and a number of columns (two columns in the embodiment). The store is moved horizontally by means of a motor 25. The handling unit 22 will now be explained in detail with reference to Figure 3. A slide mechanism 28 is attached to a base plate 26 fixed to the transfer elevator 18 through a coaxial speed reducer 27. A wafer chuck 29 is attached to the slide mechanism 28.

The base plate 26 has a motor 30 fixed thereto. The output shaft 31 of the motor 30 and the input shaft 32 of the speed reducer 27 are connected via a timing gear 33, a timing belt 34, and a further timing gear 35. The slide mechanism 28 is fixed to the output shaft 36 of the speed reducer 27. The reducer 27 has a hollow central portion 37 through which pass a cable 38 and a vacuum hose 39 from the wafer chuck.

The slide mechanism 28 includes a guide bar 40 which extends horizontally and intersects the rotary axis of the speed reducer 27. It further includes a rotatable screw rod 41 extending parallel to the guide bar 40. The guide bar 40 has a slider 42 which engages with the screw rod 41 through a nut block 43. A slide motor 44 at the side of the guide bar 40 is connected to the screw rod 41 through a timing pulley 45, a timing belt 46, and a further timing pulley 47.

The slide mechanism 28 has a set of limit sensors 48 and 49 for detecting the ends of travel of the slider 42, and a set of shield plates 50 and 51 for triggering these limit sensors 48 and 49.

The wafer chuck 29 has five chuck plates 54, 55, 56, 57, 58 which are spaced apart by the same interval as the wafers when stored in a cassette. The chuck plates are thin and hollow, with suction holes 58 in the upper surface communicating with the interior of the plates. The interior of the chuck plates are connected to a vacuum source via magnetic valves 59, 60, 61, 62, 63.

The columns of the cassette storing compartments 24 are named column A and column B and the rows of storing compartments 24 are numbered from the bottom upwards. Thus, they are referred to as A1, A2 .....B1, B2 .... As shown in Figures 5, 7, 8 and 9, a cassette in which dummy wafers are stored is denoted 7b, in which monitor wafers are stored is denoted 7c, and a cassette in which product wafers are stored is denoted 7a. These cassettes are stored in predetermined positions in the storing compartments 24.

The handling unit 22 shown in Figure 3 takes the desired wafers 1 out of the cassette storing compartments 24 and transfers them to the boat 2, arranging them in a predetermined manner. In this process, the handling unit 22 and the cassette store 19 first move by means of motors 23 and 25 so that the handling unit is opposite the desired cassette 7. Then the slide motor 44 rotates the screw rod 41 and the wafer chuck 29 slides along the slide mechanism to insert the chuck plates 53, 54, 55, 56, 57 between respective pairs of wafers 1. The elevating motor 23 elevates the wafer chuck 29 a little and separates five wafers 1 from the remaining wafers below. The wafers 1 received are then sucked into positive engagement with the chuck plates when the magnetic valves 59, 60, 61, 62, 63 are activated. Then the wafer chuck slides back along the slide mechanism and the wafers 1 are removed from the cassette 7. The motor 30 rotates the slide mechanism 28 via the timing gear 33, the timing belt 34, the further timing gear 35, and the speed reducer 27. The elevating motor 23 moves the wafer chuck 29 to the appropriate height with respect to the boat 2. Then the slide motor 44 advances the wafer chuck 29 to insert the wafers 2 into the boat 2. The magnetic valves 59, 60, 61, 62, 63 are closed after the wafers have been inserted, the elevating motor 23 then lowers the wafer chuck 29 a little to leave the five wafers in the boat 2 and the slide motor 44 moves the wafer chuck 29 back along the slide mechanism and withdraws the chuck plates from the boat.

Repeating the operations above, all the wafers may be transferred from the cassette store 19 to the boat 2. Reversing the operations above, wafers may be transferred back from the boat 2 to the cassette store 19.

By suitably combining the transport procedures described above and controlling the combined procedures, wafers 1 may be transferred to the boat 2 in the desired arrangement.

The control method and apparatus will now be described with reference to Figures 4 to 9. Before a transfer operation takes place, a number of control parameters are entered into the input board 70. These are: the positions (a) of the product wafer cassette 7a, the dummy wafer cassette 7b, the monitor wafer cassette 7c, as they are stored in the wafer storing racks 24; the number (b) of upper dummy wafers; the number (c) of lower dummy wafers; the number (d) of monitor wafers; the position (e) of the monitor wafers; the number (f) of the product wafers.

A main control portion 71 is programmed to output sequential control commands in dependence on the above parameters and to display operating conditions and guidance messages on a display 77 connected to it. The motor controllers 72, 73, 74, 75 receive feed-back signals from the position sensor 64 and respective encoders 65, 66, 67 and drive the rack transverse travelling motor 25, the elevating motor 23, the rotation motor 30 and the slide motor 44 while monitoring them so as to follow the control commands from the main control portion 71. The magnetic valve control portion 76 controls the positions of each of the magnetic valves which depends on how many wafers are to be picked up.

After activating the respective motors 25, 23, 30, 44 and magnetic valves 59, 60, 61, 62, 63 according to the control commands, the motor controllers 72, 73, 74, 75, 76 output a complete or finish command to the main control apparatus 71. The main control apparatus 71 then outputs the next control command of the program sequence.

An example sequence of operations will now be described in detail.

Consider that an operator has loaded the dummy cassettes 7b to the position A1 of the cassette storing compartments 24, the monitor cassette 7c to the position B1, and the product cassettes 7a to the remaining positions. The positions of the respective cassettes are entered on the input board 70 as control parameters (a). Suppose that the number of upper dummy wafers 1b is eight and the number of lower dummy wafers 1b is twelve, then b=8 and c=12 are set as the control parameters (b) and (c). In this case, the total number of dummy wafers fulfils the condition $\text{b+c = 5n}$ , where n is an integer. Suppose that the number of monitor wafers 1c is five, and the number of product wafers 1a situated between the monitor wafers is twenty five, control parameters of d=5 and f=25 are sequentially inputted. The number of product wafers may be any multiple of 5. The value of twenty five has been chosen in this example because it is the standard number contained in a cassette 7.

After the control parameters are set and the start button is pressed, the transfer operation commences.

The motor controller 72 for the rack transverse travelling motor 25 and the motor controller 73 for the elevating motor 23 are driven to move the handling unit 22 to a point adjacent to the position A1 of the wafer storing compartments 24. Completion of the movement of the handling unit 22 and the wafer storing compartments 24 is indicated by a feed-back signal sent from the encoder 65 and the position sensor 64. This completion signal is sent to the main control apparatus 71 via the motor controllers 72 and 73. After receiving the completion signal, the main control apparatus 71 outputs commands to the elevating motor controller 73, the rotation motor controller 74, the slide motor controller 75 and the magnetic valve controller 76 and they activate the respective motors and magnetic valves. The operation of each motor 23, 30, 44 is monitored by the encoders 65, 66, 67 and when the operations are finished a completion signal is sent to the main controller 71. In this way, the sequence of operations to transfer a boat load of wafers is controlled. The control of the movement of the handling unit 22 to the storing positions of the monitor wafer cassette 7c and the product wafer cassette 7a is similar to that explained above.

The sequence of operations by which a boat load of wafers having the above arrangement is transferred will now be described in detail.

The operation to install eight dummy wafers in the top of the boat 2, as shown in Figure 5, comprises three stages shown by the lines marked ①, ② and ③ in Figure 5. The lower five dummy wafers 1b in the cassette 7b are first engaged by the chuck and transferred to the top five places in the boat 2 as shown by line ①. Then the next five dummy wafers in the cassette 7b are transferred to the boat 2 and inserted in the five places below the previously transferred wafers (see line ②). Then the lowest two dummy wafers 1b now in the boat 2 are engaged by the upper two chuck plates 53 and 54 (see Figure 10) and transferred to the lowest two positions in the boat 2 (see line ③). The operation to install twelve dummy wafers in the bottom of the boat 2 starts with the operation shown by line ③. Five more dummy wafers 1b are then transferred along movement line ④. The transfer operation is temporarily stopped at this point and the five dummy wafers shown by dotted lines in Figure 5 at the bottom of the boat are not placed at this stage.

The remaining wafers of all types are sequentially transferred as shown in Figure 6 as indicated by the movement lines ① - 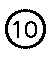 , working from the top to the bottom of the boat.

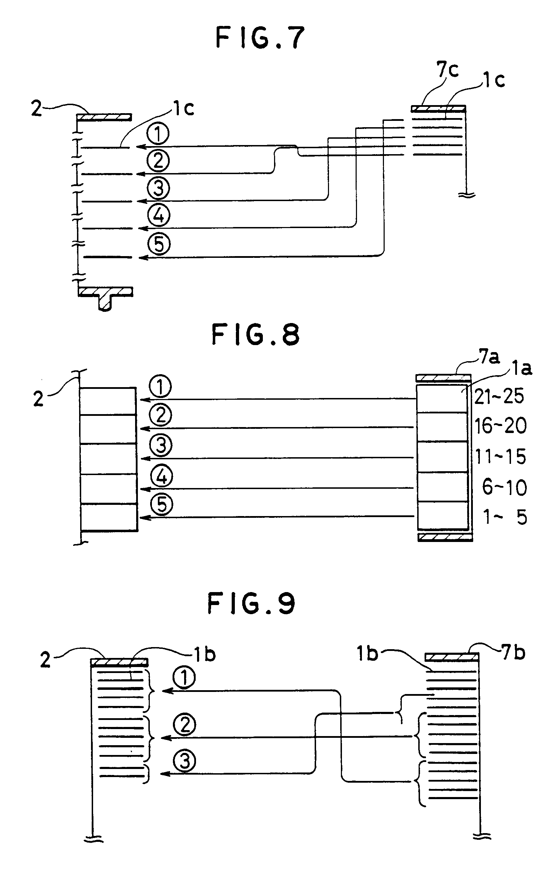

Referring to Figure 7, the monitor wafers 1c are transferred one-by-one as shown by the movement lines ① - ⑤ in Figure 7. The lowest monitor wafer in the cassette 7c is engaged by the top chuck plate 53 and inserted into the boat 2. This operation is then repeated, working from the top of the boat 2 to the bottom. Regarding the transfer of the product wafers 1a, five wafers 1a are engaged by the chuck at a time and taken from the top of the cassette 7a of product wafers 1a and placed in the boat 2 working from the top to the bottom of the boat (see lines ① - ⑤ in Figure 8). It should be noted that twenty five wafers 1a are contained by the cassette 7a, so that five transfer procedures are sufficient to transfer all wafers in the cassette and it is not necessary to transfer wafers in batches of less than five.

Another example will now be considered in which the number of dummy wafers 1b is twelve at the top of the boat, and three at the bottom. In this case the transfer of the lower set of dummy wafers will be described with reference to Figure 9.

The transfer procedure for the upper dummy wafers comprises the transfer of two batches of five wafers followed by the transfer of a batch of only two wafers (see lines ① - ③). It should be noted that the three lower dummy wafers are then transferred after the product wafers and the monitor wafers. In this case, sufficient space is provided under the wafer arrangement in the boat 2, so that no interference occurs between the wafer chuck 29 and the boat 2 during the transfer procedure for the lower dummy wafers.

When the number of the upper dummy wafers to be transfered is smaller than five, the transfer procedures shown by the lines ② , ③ and ④ in Figure 5 are followed. The transfer of the remaining wafers can be done after the transfer of the product wafers and the dummy wafers.

It is to be understood that the transfer of wafers from the boat 2 to the cassette 7a, 7b, 7c will be done by reversing the transfer procedures above.

As mentioned above, since the number of wafers contained in the cassettes is twenty five, it is preferable to use a system for transferring five wafers at a time. The total number of dummy wafers placed at the top and the bottom of the boat 2 is 5 x n, where n is an integer. When a batch of less than five dummy wafers is transferred, i.e. a fractional handling, this is completed in a single handling period, i.e. within the time taken to transfer a single wafer. The monitor wafers are handled individually and it is possible to arrange these wafers in any manner desired. Because the product wafers are transferred five at a time, the transfer mechanism of the present invention is very fast.

The pitch or spacing of the openings of the cassettes is 3/16 inches (4.76mm) for 6" (15.24cm) wafers and 1/4 inch (6.35mm) for 8" (20.32cm) wafers. Consequently, it is desirable to install some device for changing the pitch of the chuck. A pitch changing mechanism is shown in Figure 10.

A set of sliding base plates 81, 82, 84, 85 are slidably fitted on guide shafts 80. The chuck plates 53, 54, 55, 56, 57 are attached to the sliding base plates 81, 82, 84 and 85 and to a supporting base plate 83.

A screw shaft 86 extends through the sliding base plates 81, 82, 84, 85 and may be rotated by means of a pitch control motor 87. The degree of rotation of the control motor 87 is detected by an encoder 88.

The screw shaft 86 is rotatably fitted to the support base plate 83. The sliding base plate 82 engages with the screw shaft 86 through a first engagement portion 89a and the sliding base plate 81 engages with the screw shaft 86 through a second engagement portion 90a. The screw shaft 86 engages with the sliding base plate 84 through a third engagement portion 89a and with the sliding base plate 85 through a fourth engagement portion 90b. The screw thread of the first engagement portion 89a has the same pitch as and the reverse thread direction to that of the third engagement portion 89b and that of the second engagement portion 90a has the same pitch as and the reverse thread direction to the fourth engagement portion 90b. The pitch of the second and the fourth engagement portions 90a and 90b is twice that of the first and the third engagement portions 89a and 89b. Consequently, rotation of the pitch adjusting motor 87 moves the chuck plates 53, 54, 55, 56, 57 relative to each other whilst keeping the gaps between adjacent plates the same for all the plates.

It is possible for a controller (not shown) to adjust the pitch control motor 87 to operate in response to a command from the main control apparatus 71. The main control apparatus would then need a corresponding control parameter to be set and inputted to the input board 70. This would make the wafer transfer method and mechanism operate even if there were a difference between the wafer storing pitches of the cassette and the boat.

It may thus be seen that the wafer transfer system and the control apparatus for the system of the present invention may be applied to the conventional diffusion apparatus which employs wafer cassettes which are arranged horizontally as shown in Figure 12.

Thus in the present invention, the wafers are transferred efficiently five at a time and since the number of wafers in each cassette is twenty five, batches of product wafers comprising less than five product wafers do not need to be transferred. Furthermore, the dummy wafers are transferred with the minimum number of operations.

Because the transfer functions are carried out with a small number of operations, a simple sequence program can be used in the control of the wafer transfer mechanism.

Because batches of less than five wafers can be handled, any arrangement of wafers in a boat may be achieved and it is not necessary to arrange the wafers in the cassettes. The present invention enables the arrangement of wafers to be easily changed by changing the control parameters fed into the input board.

## Claims

1. A method of transferring product wafers, dummy wafers and monitor wafers between respective stores and a boat in which the wafers are in a predetermined arrangement in a vertical chemical vapour deposition diffusion apparatus characterised in that the product wafers (1a) are transferred in batches of five, the dummy wafers (1b) are transferred in batches of five or less and the monitor wafers (1c) are transferred individually.

2. A method as claimed in claim 1 wherein the dummy wafers are positioned at the top and bottom of the boat, characterised in that the total number of dummy wafers is a multiple of five.

3. A method as claimed in claim 2, characterised in that a number of dummy wafers (1b) at the bottom of the boat (2) is more than five and that the method includes positioning a multiple of five dummy wafers (1b) at the top of the boat and then transferring a number of dummy wafers (1b) which is less than five from the top of the boat to the bottom of the boat.

4. A method as claimed in claim 2, characterised in that the number of dummy wafers (1b) in the bottom of the boat (2) is less than five and that the method includes transferring a batch of less than five dummy wafers (1b) to the top of the boat, transferring the product wafers (1a) and monitor wafers (1c) into the boat and then transferring the appropriate number of dummy wafers to the bottom of the boat.

5. A wafer transfer mechanism for transferring product wafers, monitor wafers and dummy wafers between respective wafer storage cassettes and a boat in a chemical vapour deposition diffusion apparatus according to the method of claim 1, the mechanism comprising a wafer chuck (29), a rotatable slide mechanism (28) for moving the wafer chuck in the radial direction and a transfer elevator (18), characterised in that the transfer elevator (18) is arranged to move the slide mechanism (28) vertically, that a cassette store (19) is situated adjacent the transfer elevator (18) and that the wafer chuck (29) is constructed to engage and retain five wafers (1a, 1b, 1c) at a time.

6. A mechanism as claimed in claim 5, characterised in that the wafer chuck (29) comprises five chuck plates (53 to 57) adapted to retain a respective wafer by the application of suction, each chuck plate being associated with a valve (59 to 63), e.g. of magnetic type arranged to control the application of the suction by that chuck plate.

7. A mechanism as claimed in claim 5 or claim 6 characterised in that the cassette store (19) is horizontally movable and comprises a plurality of compartments (24) arranged in a plurality of horizontal rows and vertical columns.

8. A mechanism as claimed in claim 6 or claim 7, characterised in that the pitch of the chuck plates (53 to 57) may be varied.

9. A mechanism as claimed in claim 8, characterised in that the central chuck plate (55) is fixed relative to the chuck (29) and that the remaining chuck plates (53, 54, 56, 57) are in threaded engagement with a threaded shaft, the threads of the chuck plates above the central chuck plate (55) being of the opposite sense of those below the central chuck plate, the pitch of the threads of the two outer chuck plates (53,57) being greater than that of the two chuck plates (54,56) adjacent the central chuck plate (55).

10. A mechanism as claimed in any one of claims 5 to 9, characterised by a slide motor (44) for moving the wafer chuck (29) in the radial direction, a rotary motor (30) for rotating the slide mechanism (28), a controller (76) for controlling the valves (59 to 63) associated with the wafter chuck (29), a controller (75) for controlling the slide motor (44), a controller (74) for controlling the rotary motor (30), a controller (73) for controlling the transfer elevator (18), an input board (70) for inputting the operating parameters and a main controller (71) for controlling the operating sequence of the mechanism and for issuing commands to the controllers (73,74,75).

## Patentansprüche

1. Verfahren zum Transport von Produkt-, Dummy- und Monitor-Halbleiterplättchen zwischen jeweiligen Speichern und einem Schiff, in welchem die Halbleiterplättchen sich in einer vorgegebenen Anordnung in einem Diffusionsapparat mit chemischer Aufdampfung befinden, **dadurch gekennzeichnet,** **daß** die Produkt-Halbleiterplättchen (1a) in Chargen von fünf transportiert werden, die Dummy-Halbleiterplättchen (1b) in Chargen von fünf oder weniger transportiert werden und die Monitor-Halbleiterplättchen (1c) einzeln transportiert werden.

2. Verfahren nach Anspruch 1, worin die Dummy-Halbleiterplättchen an dem oberen Bereich und am Bodenbereich des Schiffes angeordnet werden, **dadurch gekennzeichnet, daß** die Gesamtanzahl der Dummy-Halbleiterplättchen ein Vielfaches von Fünf ist.

3. Verfahren nach Anspruch 2, **dadurch gekennzeichnet, daß** die Anzahl der Dummy-Halbleiterplättchen (1b) am Bodenbereich des Schiffes (2) nicht mehr als Fünf beträgt und daß das Verfahren die Anordnung eines Vielfachen von Fünf von Dummy-Halbleiterplättchen (1b) am oberen Bereich des Schiffes und den Transport einer Anzahl von Dummy-Halbleiterplättchen (1b) umfaßt, welche weniger als fünf beträgt vom oberen Bereich des Schiffes zum Bodenbereich des Schiffes.

4. Verfahren nach Anspruch 2, **dadurch gekennzeichnet, daß** die Anzahl der Dummy-Halbleiterplättchen (1b) im Bodenbereich des Schiffes (2) weniger als fünf beträgt und daß das Verfahren umfaßt den Transport einer Charge von weniger als fünf Dummy-Halbleiterplättchen (1b) zum oberen Bereich des Schiffes, den Transport der Produkt-Halbleiterplättchen (1a) und der Monitor-Halbleiterplättchen (1c) in das Schiff und anschließendem Transport der geeigneten Anzahl von Dummy-Halbleiterplättchen zum oberen Bereich des Schiffes.

5. Vorrichtung zum Transport von Produkt-, Monitor- und Dummy-Halbleiterplättchen zwischen jeweiligen Halbleiterplättchen-Speicherkassetten und einem Schiff in einem Diffusionsapparat mit chemischer Aufdampfung gemäß dem Verfahren von Anspruch 1, wobei die Vorrichtung umfaßt einen Halbleiterplättchen-Halter (29), einen drehbaren Gleitmechanismus (28) zum Bewegen des Halters in radialer Richtung und eines Transporthebers (18), **dadurch gekennzeichnet, daß** der Transportheber (18) so angeordnet ist, daß er den Gleitmechanismus (28) vertikal bewegt, daß ein Kassettenspeicher (19) nahe dem Transportheber (18) vorgesehen ist, und daß der Halter (29) so aufgebaut ist, daß er fünf Halbleiterplättchen (1a, 1b, 1c) auf einmal ergreift und hält.

6. Vorrichtung nach Anspruch 5, **dadurch gekennzeichnet, daß** der Halbleiterplättchen-Halter (29) fünf Halterplatten (53 - 57) umfaßt, welche jeweils zum Halten eines Halbleiterplättchens durch Anwendung von Saugkraft geeignet sind, wobei jede Halterplatte mit einem Ventil (59 - 63), z.B. des magnetischen Typs, versehen ist, das zur Steuerung der Anwendung des Saugens durch die Halterplatte vorgesehen ist.

7. Vorrichtung nach Anspruch 5 oder Anspruch 6, **dadurch gekennzeichnet, daß** der Kassettenspeicher (19) horizontal beweglich ist und eine Anzahl von Abteilen (24) umfaßt, welche in einer Anzahl von horizontalen Zeilen und vertikalen Spalten angeordnet sind.

8. Vorrichtung nach Anspruch 6 oder Anspruch 7, **dadurch gekennzeichnet, daß** die Abstände der Halteplatten (53-57) zueinander verändert werden können.

9. Vorrichtung nach Anspruch 8, **dadurch gekennzeichnet, daß** die mittlere Halterplatte (55) relativ zum Halter (29) fixiert ist und daß die verbleibenden Halterplatten (53, 54, 56, 57) in Gewindeeingriff mit einer Gewindewelle stehen, wobei die Gewinde der Halterplatten, welche sich über der mittleren Halterplatte (55) befinden, in entgegengesetzter Richtung verlaufen im Vergleich zu denjenigen, welche sich unter der mittleren Halterplatte befinden, und wobei die Steigung der Gewinde der zwei äußeren Halterplatten (53,57) größer ist als diejenige der zwei Halterplatten (54,56) nahe der mittleren Halteplatte (55).

10. Vorrichtung nach einem der Ansprüche 5 - 9, **gekennzeichnet dadurch** einen Gleitmotor (44) zum Bewegen des Halbleiterplättchen-Halters (29) in radialer Richtung, ein Drehmotor (30) zum Drehen des Gleitmechanismus (28), eine Steuerung (76) zum Steuern der Ventile (59 - 63), welche in Verbindung mit den Halbleiterplättchen-Haltern (29) stehen, eine Steuerung (75) zum Steuern des Gleitmotors (44), eine Steuerung (74) zum Steuern des Drehmotors (30), eine Steuerung (73) zum Steuern des Transporthebers (18), ein Eingabebrett (70) zum Eingeben der Betriebsparameter und eine Hauptsteuerung (71) zum Steuern des Betriebsablaufs der Vorrichtung und zum Ausgeben von Befehlen an die Steuerungen (73,74,75).

## Revendications

1. Procédé de transfert de plaquettes formant produit, plaquettes factices et plaquettes de contrôle entre des magasins respectifs et une nacelle, dans lequel les plaquettes sont selon un agencement prédéterminé dans un dispositif vertical de diffusion par dépôt de vapeur chimique, caractérisé en ce que les plaquettes (1a) formant produit sont transférées par lot de cinq, les plaquettes factices (1b) sont transférées par lot de cinq ou moins et les plaquettes de contrôle (1c) sont transférées de manière individuelle.

2. Procédé selon la revendication 1, dans lequel les plaquettes factices sont positionnées au niveau de la partie supérieure et de la partie inférieure de la nacelle, caractérisé en ce que le nombre total de plaquettes factices est un multiple de cinq.

3. Procédé selon la revendication 2, caractérisé en ce que le nombre de plaquettes factices (1b) situées au niveau du fond de la nacelle (2) est supérieur à cinq et en ce que le procédé comporte le positionnement d'un multiple de cinq plaquettes factices (1b) au niveau de la partie supérieure de la nacelle et transfère ensuite un nombre de plaquettes factices (1b) qui est plus petit que cinq depuis la partie supérieure de la nacelle vers la partie inférieure de la nacelle.

4. Procédé selon la revendication 2, caractérisé en ce que le nombre de plaquettes factices (1b) situées dans la partie inférieure de la nacelle (2) est plus petit que cinq et en ce que le procédé consiste à transférer un lot de moins de cinq plaquettes factices (1b) vers la partie supérieure de la nacelle, transférer les plaquettes formant produit (1a) et les plaquettes de contrôle (1c) jusque dans la nacelle et ensuite transférer le nombre approprié de plaquettes factices vers la partie inférieure de la nacelle.

5. Mécanisme de transfert de plaquette destiné à transférer des plaquettes formant produit, des plaquettes de contrôle et des plaquettes factices entre des cassettes de stockage de plaquettes respectives et une nacelle située dans un dispositif de diffusion par dépôt de vapeur chimique selon le procédé de la revendication 1, le mécanisme comportant un mandrin (29) pour plaquettes, un mécanisme (28) formant coulisseau pouvant tourner destiné à déplacer le mandrin pour plaquettes dans la direction radiale et un élévateur de transfert (18), caractérisé en ce que l'élévateur de transfert (18) est agencé pour déplacer le mécanisme (28) formant coulisseau verticalement, en ce que qu'un magasin (19) formant cassette est situé adjacent à l'élévateur de transfert (18) et en ce que le mandrin pour plaquettes (29) est construit pour venir en contact avec cinq plaquettes (1a, 1b, 1c) à la fois et les retenir.

6. Mécanisme selon la revendication 5, caractérisé en ce que le mandrin (29) pour plaquettes comporte cinq plaques de mandrin (53 à 57) adaptées pour retenir une plaquette respective par application d'une aspiration, chaque plaque de mandrin étant associée à une vanne (59 à 63), par exemple du type magnétique agencée pour commander l'application de l'aspiration par cette plaque de mandrin.

7. Mécanisme selon la revendication 5 ou 6, caractérisé en ce que le magasin (19) formant cassette est mobile horizontalement et comporte plusieurs compartiments (24) agencés selon plusieurs rangées horizontales et colonnes verticales.

8. Mécanisme selon la revendication 6 ou 7, caractérisé en ce que le pas des plaques de mandrin (53 à 57) peut être modifié.

9. Mécanisme selon la revendication 8, caractérisé en ce que la plaque centrale (55) de mandrin est fixe par rapport au mandrin (29) et en ce que les plaques de mandrin restantes (53, 54, 56, 57) sont en prise filetée avec un arbre fileté, les filets des plaques de mandrin situées au-dessus de la plaque centrale (55) de mandrin étant de sens opposé à ceux situés en dessous de la plaque centrale de mandrin, le pas des filets des deux plaques de mandrin extérieures (53, 57) étant plus grand que celui des deux plaques de mandrin (54, 56) adjacentes à la plaque centrale (55) de mandrin.

10. Mécanisme selon l'une quelconque des revendications 5 à 9, caractérisé en ce qu'il comporte un moteur (44) de coulisseau destiné à déplacer le mandrin (29) pour plaquette dans la direction radiale, un moteur rotatif (30) pour faire tourner le mécanisme (28) formant coulisseau, un dispositif de commande (76) pour commander les vannes (59 à 63) associées au mandrin (29) pour plaquettes, un dispositif de commande (75) pour commander le moteur (44) de coulisseau, un dispositif de commande (74) pour commander le moteur rotatif (30), un dispositif de commande (73) pour commander l'élévateur de transfert (18), une carte d'entrée (70) pour entrer les paramètres de fonctionnement et un dispositif principal de commande (71) pour commander la séquence de fonctionnement du mécanisme et pour émettre les commandes vers les dispositifs de commande (73, 74, 75).
